(19) Europäisches Patentamt

European Patent Office

Office européen des brevets

(11) Veröffentlichungsnummer: **0 294 610 B1**

(12) # EUROPÄISCHE PATENTSCHRIFT

(45) Veröffentlichungstag der Patentschrift: **10.02.93**

(21) Anmeldenummer: **88107657.4**

(22) Anmeldetag: **13.05.88**

(51) Int. Cl.5: **C25D 13/04**, G03G 13/00, B41C 1/10

(54) **Einstufiges elektrochemisches Bilderzeugungsverfahren für Reproduktionsschichten.**

(30) Priorität: **26.05.87 DE 3717652**

(43) Veröffentlichungstag der Anmeldung:
**14.12.88 Patentblatt 88/50**

(45) Bekanntmachung des Hinweises auf die
Patenterteilung:
**10.02.93 Patentblatt 93/06**

(84) Benannte Vertragsstaaten:
**DE FR GB**

(56) Entgegenhaltungen:
**EP-A- 0 155 231**
**DE-C- 3 305 355**

**DERWENT ACCESSION NR. 76-64 130X**
**[34],1,5,6 Ouestel Telesystemes (WPI) DER-**
**WENT PUBLICATIONS LTD., London & JP-**
**A-51078406**

(73) Patentinhaber: **HOECHST AKTIENGESELL-**
**SCHAFT**
**Postfach 80 03 20**
**W-6230 Frankturt am Main 80(DE)**

(72) Erfinder: **Pliefke, Engelbert, Dr. Dipl.-Chem.**
**Drususstrasse 52**
**W-6200 Wiesbaden(DE)**

**Beschreibung**

Die Erfindung betrifft ein Verfahren zur elektrochemischen Abscheidung einer polymeren organischen Substanz auf einem leitfähigen Substrat, wobei das Substrat mit einer elektrisch leitfähigen, wäßrigen Lösung der organischen Substanz kontaktiert ist und zwischen dem Substrat und mindestens einer Elektrode eine Gleichspannung anliegt.

Bei der Herstellung von Offsetdruckformen oder von Photoresists (beides im weiteren "Kopiermaterialien" genannt) werden strahlungs(licht)empfindliche Reproduktionsschichten verwendet, die im allgemeinen vom Verbraucher oder vom industriellen Hersteller auf einen Schichtträger aufgebracht werden. Als Schichtträger für diese Kopiermaterialien werden Metalle, wie Zink, Magnesium, Chrom, Kupfer, Messing, Stahl, Silicium, Aluminium oder Kombinationen dieser Metalle, Kunststoffolien, Papier oder ähnliche Materialien, eingesetzt. Diese Schichtträger können ohne eine modifizierende Vorbehandlung, bevorzugt aber nach Durchführung einer Oberflächenmodifizierung, wie einer mechanischen, chemischen und/oder elektrochemischen Aufrauhung, einer Oxidation und/oder einer Behandlung mit Hydrophilierungsmitteln (z. B. bei Trägern für Offsetdruckplatten), mit der strahlungsempfindlichen Reproduktionsschicht beschichtet werden. Die üblichen strahlungsempfindlichen Reproduktionsschichten enthalten neben mindestens einer strahlungsempfindlichen Verbindung meist noch ein organisches Bindemittel (z. B. Harze) und gegebenenfalls auch noch Weichmacher, Pigmente, Farbstoffe, Netzmittel, Sensibilisatoren, Haftvermittler, Indikatoren und andere übliche Hilfsmittel. Diese Reproduktionsschichten werden nach ihrer Bestrahlung (Belichtung) entwickelt, um aus ihnen ein Bild zu erzeugen, wonach beispielsweise eine Druckform oder ein Photoresist erhalten wird. Bei elektrophotographisch arbeitenden Schichten entspricht dem Entwickeln das Entschichten. Im Rahmen der vorliegenden Erfindung sind unter dem Begriff "Reproduktionsschichten" jedoch auch solche zu verstehen, die keine strahlungsempfindliche Verbindung, aber die übrigen der aufgeführten Komponenten, d. h. insbesondere ein organisches Bindemittel, enthalten.

Es sind aus dem Stand der Technik Verfahren bekannt, bei denen eine Druckform auch ohne einen Bestrahlungs und/oder Entwicklungsschritt und damit auch ohne einen Einsatz der sonst üblichen Reproduktionsschichten mit einem Gehalt an einer strahlungsempfindlichen Verbindung hergestellt werden.

- Aus der DE-C 24 33 448 (= US-A 4 086 853) ist der Einsatz eines elektrisch-empfindlichen Aufzeichnungsblattes mit a) einer hydrophoben Unterschicht (z. B. aus Polyester), b) einer darauf angeordneten elektrisch leitenden, durch Stromeinwirkung mittels eines Stifts örtlich entfernbaren, hydrophilen Schicht (z. B. aus Aluminium) und c) einer Schicht, die nach der Stromeinwirkung von der Schicht gemäß b) ablösbar ist (z.B. aus einem Cellulosederivat, einem Weichmacher und einem Pigment) bekannt.
- Die DE-A 25 14 682 (= GB-A 1 490 732) beschreibt den Einsatz eines elektrisch-empfindlichen Aufzeichnungsmaterials mit a) einer elektrisch-leitenden, durch Stromeinwirkung nicht entfernbaren, oleophilen Schicht und b) einer darauf angeordneten, durch Stromeinwirkung mittels eines Stifts örtlich entfernbaren, oleophoben Schicht aus Silikonkautschuk.
- Weiterhin offenbart die EP-A 0 030 642 ein Verfahren zur Herstellung einer Druckform aus einem flächigen Material mit a) einer hydrophoben Trägerschicht (z. B. aus Polyester), b) einer hydrophilen, elektrisch-leitenden Zwischenschicht (z. B. aus Aluminium) und c) einer abschließenden, dielektrischen Schutzschicht (z. B. aus $Al_2O_3$) durch Elektroerosion, wobei durch Einwirkung von Elektroden sowohl die Schicht c) als auch b) entfernt werden.

Alle diese Verfahren beruhen auf einer bildmäßigen Entfernung von Schichtbestandteilen durch elektrochemischen Abbau.

Die EP-A 0 155 231 beschreibt die Elektrotauchlackierung einer Leiterplatte, die nach der Lackierung durch bildmäßige Belichtung und Entwicklung weiterverarbeitet wird.

Die EP-B 0 089 510 (= US-A 4 376 814) beschreibt das elektrochemische Abscheiden eines hydrophilen Polymers auf einer Druckplatte.

Beide Verfahren verwenden zwar die Elektrotauchlackierung zum Abscheiden von Polymeren, verwenden jedoch im Verfahren keine bildmäßige Differenzierung.

Eine bildmäßige Differenzierung wird in folgenden Veröffentlichungen beschrieben:
Die US-A 4 519 876 beschreibt ein elektrisch leitfähiges Substrat mit einer isolierenden Schicht, die nach Laserbelichtung bildmäßig entfernt werden kann. Danach folgt eine galvanische Metallabscheidung in den freien, nicht mehr geschützten Teilen.

In der JP-A 51-078 406 wird ein analoges Verfahren unter Verwendung einer Siebdruckmaske als Vorlage beschrieben, wobei ebenfalls in den nicht abgedeckten Stellen Metalle galvanisch abgeschieden werden.

Darüber hinaus sind in der Patentliteratur Verfahren bekannt, die auf elektrophotographischem Wege bzw. durch Leitfähigkeitsbilder Abscheidungen betreiben.

So beschreiben die US-A 3 106 157 und 3 085 051 Verfahren, bei denen das durch eine bildmäßige Belichtung erzeugte Leitfähigkeitsbild zur Abscheidung von Indium- bzw. Nickelatomen dient.

Die US-A 3 095 808 beschreibt die Ausnutzung der Photoleitfähigkeit nach bildmäßiger Belichtung zur Abscheidung eines Fe-, Cu-, Ni- oder Co-Salzes der Rubeanwasserstoffsäure.

In der US-A 3 106 155 wird die "Entwicklung" des durch bildmäßige Belichtung erzeugten Photoleitfähigkeitsbildes durch Polymere, wie z. B. durch Celluloseacetatphthalat, beschrieben.

Alle diese Verfahren setzen eine bildmäßige Belichtung voraus, die ein Leitfähigkeitsbild erzeugt, das durch weitere Maßnahmen fixiert wird.

Bei der aus dem Stand der Technik bekannten Elektrotauchlackierung wird durch Anlegung von Strom in einem wasserhaltigen Elektrolytsystem entweder kathodisch oder anodisch eine ursprünglich gelöste, organische Substanz auf dem zu beschichtenden Werkstück vollflächig abgeschieden.

Aufgabe der vorliegenden Erfindung ist die Herstellung einer bildmäßigen Reproduktionsschicht in nur einer Stufe.

Gelöst wird diese Aufgabe durch ein Verfahren zur elektrochemischen Abscheidung einer polymeren organischen Substanz auf einem leitfähigen Substrat, wobei das Substrat mit einer elektrisch leitfähigen, wäßrigen Lösung der organischen Substanz kontaktiert ist und zwischen dem Substrat und mindestens einer Elektrode eine Gleichspannung anliegt, dadurch gekennzeichnet, daß die organische Substanz bei einer Stromdichte von etwa 0,01 bis 100 A/dm$^2$ durch Stromimpulse bildmäßig abgeschieden wird.

Eine mögliche Ausführungsform dieser Erfindung besteht im einfachsten Fall in einer nadelförmigen Elektrode, die in möglichst geringem Abstand von der zu bebildernden Platte geführt wird. Durch einen kurzen Strompuls gelingt es, auf der Platte eine punktförmige Abscheidung einer organischen Verbindung aus dem Elektrotauchbad zu induzieren. Durch cyclische Wiederholung dieses Verfahrens läßt sich eine ganze (Druck-)platte rasterförmig bebildern.

Auch Volltöne lassen sich durch z. B. kontinuierliches Überfahren der entsprechenden Plattenbezirke ohne Schwierigkeiten erzeugen.

Eine andere, schnellere Ausführungsform besteht in der Verwendung einer Maske, d. h., eine bildmäßige Abscheidung findet durch die Löcher in einer vor der zu bebildernden Platte befindlichen Folie statt, wobei in den Löchern die späteren Bildstellen entstehen. Der Elektrotauchlack wird dann selektiv nur an diesen, die zu bebildernde Platte nicht abdeckenden Stellen abgeschieden.

Anstelle einer vorgehaltenen Maske läßt sich für den erfindungsgemäßen Schritt natürlich auch eine bebilderte und entwickelte Druckplatte einsetzen. Durch die Elektrotauchlackierung werden dann die abzuscheidenden Substanzen in den ursprünglichen Nichtbildstellen niedergeschlagen. Nach Entfernung der ursprünglichen Bildstellen steht dann eine bildumgekehrte Platte zur Verfügung. Eine ursprüngliche Positivdruckform wird zur Negativdruckform und umgekehrt.

Die Vorteile des erfindungsgemäßen Verfahrens liegen bei der Ausführungsform mit der nadelförmigen Elektrode darin, daß digital gespeicherte Informationen direkt aus dem Computer gelesen werden können und sofort in eine Druckform bzw. eine Leiterplattenstruktur übersetzt werden können.

Bei den anderen Ausführungsformen können - durch geeignete Auswahl des abgeschiedenen Harzes - die Punktwiedergabe, die Farbannahme und die Druckauflage entscheidend verbessert werden. Durch das erfindungsgemäße Verfahren gelingt es nämlich, die Schicht extrem gut zu verankern, da auf eine spätere Entwickelbarkeit, wie sie für normale Druckplatten unerläßlich ist, verzichtet werden kann.

Im Gegensatz zu der als Stand der Technik zitierten bildmäßigen Metallabscheidung wird durch das erfindungsgemäße Verfahren der bildmäßigen Elektrotauchlackierung mit einem organischen Harz schon bei sehr geringen Ladungsmengen eine geschlossene Schicht erreicht; zudem kann durch geeignete Auswahl der organischen Substanz eine für Druckformen ideal angepaßte Balance zwischen Farbführung und Auflagestabilität erreicht werden.

Nach dem erfindungsgemäßen Verfahren ist es also möglich, aus wäßrigen Lösungen, die kein organisches Lösemittel oder andere größere Mengen an umweltbelastenden Hilfsstoffen enthalten müssen, verschiedene Arten von Harzen bildmäßig abzuscheiden. Die dabei erreichbare Auflösung entspricht der konventioneller, nicht-elektrochemisch durch Bestrahlung bebilderten und entwickelten Platten.

Die Konzentration der wäßrigen Harzlösung kann zwischen 0,1 Gew.-%, insbesondere 1 Gew.-% und der jeweiligen Sättigungskonzentration der dissoziierten Verbindung liegen, im allgemeinen sind bereits Konzentrationen bis zu 20 Gew.-% ausreichend. Wenn die Konzentration des wäßrigen Elektrolyten unter 0,1 Gew.-% liegt, dann ist meistens die Leitfähigkeit der Lösung zu niedrig, so daß die resultierende Stromdichte zu gering wird, um eine genügend rasch ablaufende Elektrotauchbebilderung zu erzielen. Die Temperatur des wäßrigen Elektrolyten kann von Raumtemperatur bis zum Siedepunkt des Elektrolytsystems reichen, bevorzugt wird jedoch eine Temperatur von 20° bis 70°C eingehalten. Ein Durchmischen des wäßrigen Elektrolyten während der Durchführung des erfindungsgemäßen Verfahrens ist im allgemeinen nicht erforderlich. Für eine einfache Bebilderung kann es auch von Vorteil sein, wenn mit einem sehr eingedickten Elektrolytsystem gearbeitet wird.

Das erfindungsgemäße Verfahren wird mit Gleichstrom, gegebenenfalls mit Modulation, durchgeführt, es kann auch gepulster Gleichstrom eingesetzt werden. Die Stromdichte liegt in einem Bereich von 0,01 bis 100 A/dm², denn oberhalb dieses Bereichs ist die Aufheizung der wäßrigen Elektrolytlösung zu stark und unterhalb die Abscheidungsgeschwindigkeit zu gering, und/oder die Bilderzeugung kann hinsichtlich der Dauer oder der Qualität negativ beeinflußt werden. Die Stromdichte steigt zu Beginn der elektrochemischen Bebilderung an, verbleibt eine gewisse Zeit auf einer Höhe und fällt gegen Ende der Behandlung wieder stark ab.

Während der elektrochemischen Bebilderung wird bei der kathodischen Abscheidung an der Kathode Wasserstoff durch Entladung von $H^+(H_3O^+)$-Ionen freigesetzt. Es wird angenommen, daß dadurch der pH-Wert lokal stark ansteigt und die bildmäßig differenzierende Abscheidung bewirkt. Analog findet bei der anodischen, bildmäßigen Elektrotauchlackierung die Ausfällung durch ein Absinken des pH-Wertes statt.

Unter dem Begriff "nadelförmig ausgebildete Elektrode" ist ein länglicher Körper aus einem möglichst inerten (d. h. sich nicht während des erfindungsgemäßen Verfahrens abbauenden) Material wie Edelstahl, Graphit, Gold oder Platin zu verstehen, der eine möglichst kleine Spitze aufweist, um eine möglichst gute Auflösung und die Erzielung feinster Bildpunkte zu ermöglichen. Diese Elektrode bzw. diese Elektroden werden in möglichst geringem Abstand über das zu bebildernde flächige Material geführt.

Das Verfahren wird anhand der folgenden Abbildungen dargestellt, ohne daß eine Einschränkung auf die gezeigten Ausführungsformen bestehen soll.

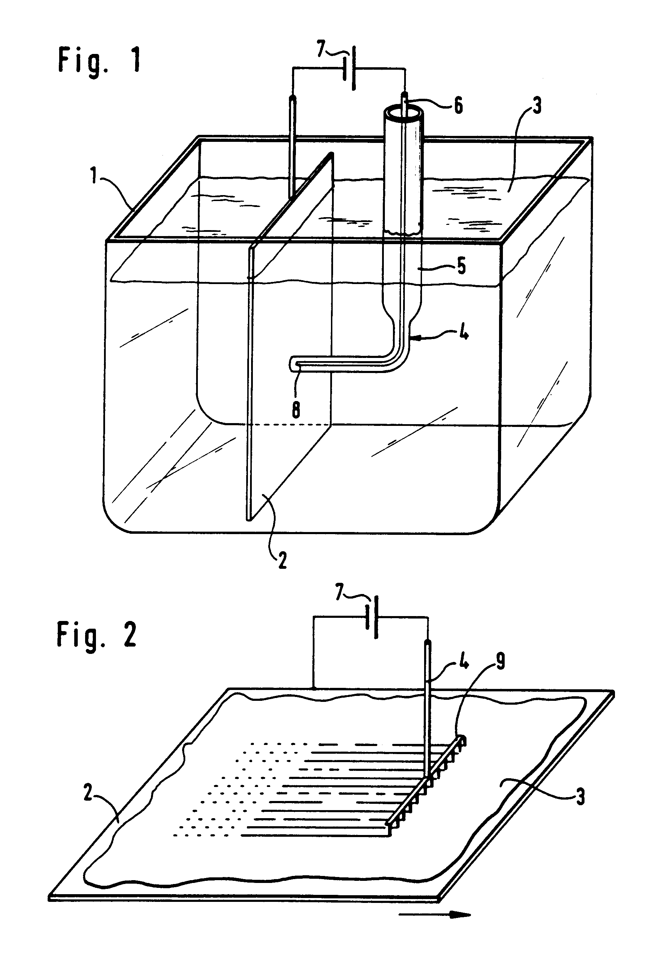

In Abb. 1 ist eine mögliche Ausführungsform dargestellt. Dabei wird in einem Badbehälter 1 die zu bebildernde Platte 2 in eine geeignete Elektrotauchlacklösung 3 eingetaucht. In einem geringen Abstand zu der Platte 2 wird die Nadelelektrode 4 geführt. Sie besteht aus einer Hülse aus isolierendem Material 5 (z. B. Glas, Kunststoff etc.), in der ein leitender Draht 6 aus einem inerten Material geführt wird, wobei die isolierende Hülse der Nadelelektrode auch noch mit der Elektrotauchlackierlösung gefüllt sein kann. Zwischen der Platte 2 und der Nadelelektrode 4 wird eine Spannung 7 angelegt, die eine bildmäßige Abscheidung des Lackes unmittelbar an der Elektrodenspitze bewirkt 8.

Zur Bebilderung größerer Flächen können auch mehrere nadelförmig ausgebildete Elektroden zum Einsatz kommen; dies kann auch zur Beschleunigung des Verfahrens möglich sein. Diese Elektroden werden, ebenso wie nur eine Elektrode, von einer Vorrichtung gesteuert, welche die Bildinformationen in digitalisierter Form enthält (z. B. "computer-to-plate"-System). Die Gegenelektrode ist das zu bebildernde Substrat.

Die Einzelheiten dieser Ausführungsform zeigt Abb. 2. Die zu bebildernde Platte 2 wird mit einer vorzugsweise geligen Elektrotauchlackierlösung 3 bedeckt, in die eine Reihe von Nadelelektroden 4 eintaucht, die voneinander elektrisch isoliert sind und einzeln kontaktiert werden können. Wird der Strom 7 auf eine Nadel in der Leiste 9 geschaltet, resultiert eine dem Stromfluß entsprechende Lackabscheidung an dieser Stelle.

Die wäßrige Elektrolytlösung muß im Verhältnis zum zu bebildernden Material und der oder den nadelförmig ausgebildeten Elektrode(n) so angeordnet sein, daß sie in Wechselwirkung mit den beiden als Elektroden wirkenden Körpern eine bildmäßige Abscheidung der Reproduktionsschicht bewirken kann, beispielsweise durch Eintauchen der Körper in die Lösung. Zu den Reproduktionsschichten zählen im erfindungsgemäßen Verfahren nicht nur die üblichen, später beschriebenen, bekannten strahlungsempfindlichen Schichten, sondern auch solche vergleichbarer Zusammensetzung, die jedoch keine strahlungsempfindliche Verbindung enthalten. Ganz allgemein sind unter Reproduktionsschichten solche Schichten zu verstehen, die im erfindungsgemäßen Verfahren eine bildmäßige Differenzierung ermöglichen.

In einer bevorzugten Ausführungsform des erfindungsgemäßen Verfahrens wird das zu bebildernde Substrat durch Eintauchen mit der bindemittelhaltigen Elektrolytlösung kontaktiert. Dabei sollte eine Kante des flächigen Materials aus der Oberfläche des Elektrolytbades herausragen, wobei an diesem Teil dann ein Stromanschluß befestigt werden kann. Eine andere Möglichkeit der Stromzufuhr liegt in der Kontaktierung über die Materialrückseite. Die nadelförmig ausgebildete Elektrode sollte gegenüber dem flächigen Substrat insbesondere in einem gleichmäßigen Abstand angeordnet sein, damit eine gleichmäßige Stromdichte an jeder Stelle des zu bebildernden flächigen Materials eingestellt werden kann. Der Vorteil des Verfahrens liegt darin, daß durch die punktweise Erzeugung der Bildstellen deren Größe durch Variation von Stromdichte und Zeit gesteuert werden kann. Die Steuerimpulse können z. B. direkt aus einem computer-to-plate-System kommen. Die unbeschichtete Rückseite des zu behandelnden flächigen Substrats sollte vorzugsweise an einem nicht leitenden Material anliegen, um einen unnötigen Verbrauch an elektrischer Energie zu vermeiden. Eine andere Möglichkeit liegt in der Abschottung der Materialrückseite, wobei die Platte im Elektrolytbad-Behälter in dichten Nuten geführt wird. Ebenso sollte(n) zweckmäßig die nadelförmig ausgebildete(n) Elektrode(n) größtenteils isoliert vorliegen.

Die erfindungsgemäß zu erzeugende Reproduktionsschicht enthält in der Regel ein polymeres Bindemittel, das unter der Einwirkung des elektrischen Stroms mittels der nadelförmig ausgebildeten Elektrode(n) bildmäßig abgeschieden wird. Als unter die Erfindung fallend werden aber auch solche Abscheidungen auf der Basis eines polymeren Bindemittels verstanden, die eine strahlungsempfindliche Verbindung enthalten, bevorzugt werden sie jedoch als strahlungsunempfindliche Schichten eingesetzt. Als Substratmaterialien kommen elektrisch-leitfähige Trägermaterialien in Frage, wozu beispielsweise solche mit Schichten von Zink, Chrom, Magnesium, Kupfer, Messing, Stahl, Silicium, Aluminium oder deren Legierungen oder Kombinationen dieser Metalle zählen. Diese können ohne eine spezielle, modifizierende Vorbehandlung mit einer geeigneten Reproduktionsschicht elektrochemisch bebildert werden, bevorzugt wird diese Bebilderung jedoch erst nach einer Oberflächenmodifizierung wie einer mechanischen, chemischen oder elektrochemischen Aufrauhung, einer Oxidation und/oder einer Behandlung mit Hydrophilierungsmitteln (insbesondere bei Trägern für Offsetdruckplatten) durchgeführt.

Zu den besonders geeigneten Substraten zur Herstellung von Offsetdruckplatten zählen solche aus Aluminium oder einer seiner Legierungen, die beispielsweise einen Gehalt von mehr als 98,0 Gew.-%, insbesondere von mehr als 98,5 Gew.-% an Al und Anteile an Si, Fe, Ti, Cu, Zn, Mn und/oder Mg aufweisen.

Die in der Praxis sehr häufig anzutreffenden Aluminiumträgermaterialien für Druckplatten werden im allgemeinen vor Aufbringen der Reproduktionsschicht noch mechanisch (z. B. durch Bürsten und/oder mit Schleifmittel-Behandlungen), chemisch (z. B. durch Ätzmittel) oder elektrochemisch (z. B. durch Wechselstrombehandlung in wäßrigen HCl- oder $HNO_3$-Lösungen) aufgerauht. Die mittlere Rauhtiefe $R_z$ der aufgerauhten Oberfläche liegt dabei im Bereich von etwa 1 bis 15 $\mu$m, insbesondere im Bereich von 1,5 bis 10 $\mu$m. Die Rauhtiefe wird nach DIN 4768 in der Fassung vom Oktober 1970 ermittelt, die Rauhtiefe $R_z$ istdann das arithmetische Mittel aus den Einzelrauhtiefen fünf aneinandergrenzender Einzelmeßstrecken.

Vor der Aufrauhung kann eine Vorreinigung des Aluminiums stattfinden; sie umfaßt beispielsweise die Behandlung mit wäßriger NaOH-Lösung mit oder ohne Entfettungsmittel und/oder Komplexbildnern, Trichlorethylen, Aceton, Methanol oder anderen handelsüblichen sogenannten Aluminiumbeizen. Der Aufrauhung oder bei mehreren Aufrauhstufen auch noch zwischen den einzelnen Stufen kann außerdem zusätzlich eine abtragende Behandlung nachgeschaltet werden, wobei insbesondere maximal 5 $g/m^2$ abgetragen werden. Als abtragend wirkende Lösungen werden im allgemeinen wäßrige Alkalihydroxidlösungen bzw. wäßrige Lösungen von alkalisch reagierenden Salzen oder wäßrige Säurelösungen auf der Basis von $HNO_3$, $H_2SO_4$ oder $H_3PO_4$ eingesetzt. Neben einer abtragenden Behandlungsstufe zwischen der Aufrauhstufe und einer gegebenenfalls nachfolgenden Anodisierstufe sind auch solche nicht-elektrochemischen Behandlungen bekannt, die im wesentlichen lediglich eine spülende und/oder reinigende Wirkung haben und beispielsweise zur Entfernung von bei der Aufrauhung gebildeten Belägen ("Schmant") oder einfach zur Entfernung von Behandlungsresten dienen; im Einsatz sind für diese Zwecke beispielsweise verdünnte wäßrige Alkalihydroxidlösungen oder Wasser.

Nach dem oder den Aufrauhverfahren kann sich dann gegebenenfalls in einer weiteren anzuwendenden Verfahrensstufe eine anodische Oxidation des Aluminiums anschließen, um beispielsweise die Abrieb- und die Haftungseigenschaften der Oberfläche des Trägermaterials zu verbessern. Zur anodischen Oxidation können die üblichen Elektrolyte wie $H_2SO_4$, $H_3PO_4$, $H_2C_2O_4$, Amidosulfonsäure, Sulfobernsteinsäure, Sulfosalicylsäure oder deren Mischungen eingesetzt werden; insbesondere werden $H_2SO_4$ und $H_3PO_4$ allein, in Mischung und/oder in einem mehrstufigen Anodisierprozeß verwendet. Die Schichtgewichte an Aluminiumoxid bewegen sich im Bereich von 1 bis 10 $g/m^2$, entsprechend einer Schichtdicke von etwa 0,3 bis 3,0 $\mu$m.

Der Stufe einer anodischen Oxidation des Trägermaterials aus Aluminium können auch eine oder mehrere Nachbehandlungsstufen nachgeschaltet werden. Dabei wird unter Nachbehandeln insbesondere eine hydrophilierende chemische oder elektrochemische Behandlung der Aluminiumoxidschicht verstanden, beispielsweise eine Tauchbehandlung des Materials in einer wäßrigen Polyvinylphosphonsäure-Lösung nach der DE-C 16 21 478 (= GB-A 1 230 447), eine Tauchbehandlung in einer wäßrigen Alkalisilikat- Lösung nach der DE-B 14 71 707 (= US-A 3 181 461) oder eine elektrochemische Behandlung (Anodisierung) in einer wäßrigen Alkalisilikat-Lösung nach der DE-A 25 32 769 (= US-A 3 902 976). Diese Nachbehandlungsstufen dienen insbesondere dazu, die bereits oftmals ausreichende Hydrophilie der Aluminiumoxidschicht noch zusätzlich zu steigern, wobei die übrigen bekannten Eigenschaften dieser Schicht mindestens erhalten bleiben.

Als strahlungs(licht)empfindliche Reproduktionsschichten sind grundsätzlich solche zu verstehen, die - in den sonst üblichen Methoden, die erfindungsgemäß jedoch nicht erforderlich sind - nach dem Bestrahlen (Belichten), gegebenenfalls mit einer nachfolgenden Entwicklung und/oder Fixierung eine bildmäßige Fläche liefern, von der gedruckt werden kann.

Zu den lichtempfindlichen Reproduktionsschichten zählen solche, wie sie z. B. in "Light-Sensitive Systems" von Jaromir Kosar, John Wiley & Sons Verlag, New York 1965, beschrieben werden: die Chromate und Dichromate enthaltenden Kolloidschichten (Kosar, Kapitel 2); die ungesättigte Verbindungen enthaltenden Schichten, in denen diese Verbindungen beim Belichten isomerisiert, umgelagert, cyclisiert oder vernetzt werden (Kosar, Kapitel 4); die photopolymerisierbare Verbindungen enthaltenden Schichten, in denen Monomere oder Präpolymere gegebenenfalls mittels eines Initiators beim Belichten polymerisieren (Kosar, Kapitel 5); und die o-Diazo-chinone wie Naphthochinondiazide, p-Diazo-chinone oder Diazoniumsalz-Kondensate enthaltenden Schichten (Kosar, Kapitel 7). Zu den geeigneten Schichten zählen auch die elektrophotographischen Schichten, d. h. solche die einen anorganischen oder organischen Photoleiter enthalten. Außer den strahlungsempfindlichen Substanzen können diese Schichten selbstverständlich noch andere Bestandteile, wie z. B. Harze, Farbstoffe oder Weichmacher, enthalten.

Die vorstehend beschriebenen strahlungsempfindliche Verbindungen enthaltenden Schichten werden im erfindungsgemäßen Verfahren - sofern sie mindestens ein Bindemittel enthalten - bevorzugt ohne Anwesenheit der strahlungsempfindlichen Verbindung eingesetzt. Insbesondere sind dann folgende lösliche organische Polymere in wäßrigen Elektrolyten geeignet: Polyamide, Polyester, Alkydharze, Polyvinylalkohol, Polyvinylpyrrolidon, Polyethylenoxid, Polyacetale, Gelatine, Celluloseether, Melamin-Formaldehydharze, Aminharze, Acrylharze und/oder Polyepoxide (z. B. auf der Basis epoxidierten Leinöls); aber auch andere elektrolytisch abscheidbare Bindemittelklassen können zur Anwendung kommen. Die Dicke der Reproduktionsschicht kann sich im Bereich von etwa 0,1 $\mu$m bis etwa 1 mm oder darüber bewegen.

In den Fällen, in denen die Reproduktionsschichten als strahlungsempfindliche Verbindungen solche enthalten, die ein negativ-arbeitendes System ergeben, empfiehlt sich die vollflächige Nachbelichtung oder Nacherhitzung des flächigen Materials von der Seite der Reproduktionsschicht her; bei positiv-arbeitendem System braucht keine spezielle Nachbelichtung durchgeführt zu werden.

Um gegebenenfalls noch höhere Druckauflagen zu erzielen, ist nach Durchführung der erfindungsgemäßen Bilderzeugung zur Erhöhung der mechanischen und/oder chemischen Stabilität der Bildstellen ein "Einbrennen" möglich, d. h., eine thermische oder damit vergleichbare Nachbehandlung des flächigen Materials.

Mit dem erfindungsgemäßen Verfahren ist also die Zusammenfassung des sonst zweistufig durchgeführten Bebilderungs- und Entwicklungsverfahrens für Reproduktionsschichten in einer Stufe möglich.

In den folgenden Beispielen und der vorstehenden Beschreibung sind die %-Angaben - wenn nicht eine andere Angabe vorliegt - auf das Gewicht bezogen. Gew.-Teile verhalten sich zu Vol.-Teilen wie g zu cm$^3$. Die zu behandelnden Reproduktionsschichten befinden sich auf leitfähigen Trägern und werden - bei den Beispielen 1 bis 37 - als Kathode in einem Gleichstromkreis geschaltet, die nadelförmig ausgebildete(n) Elektrode(n) dann als Anode(n). In den Beispielen 38 bis 51 ist das zu bebildernde Substrat die Anode. Die Elektrolyttemperatur beträgt - wenn keine andere Angabe vorliegt - 25 bis 30 ° C, der Abstand des zu behandelnden Materials von der Gegenelektrode wird so gering wie möglich gehalten, ohne daß es zu einem Kurzschluß kommt. Der Verlauf der Stromdichte kann in der Regel wie folgt dargestellt werden: Die Stromdichte steigt während einiger msec zunächst auf einen bestimmten Wert an, verbleibt einige msec auf diesem Stand und sinkt gegen Ende der elektrolytischen Entwicklung stark ab. Wenn keine speziellen Bemerkungen angegeben sind, sind die behandelten Materialien praxisgerecht.

Beispiele

Die mit dem erfindungsgemäßen Verfahren bildmäßig beschichteten Träger sind in den folgenden Beispielen elektrochemisch aufgerauhte und anodisierte Aluminiumplatten. Es wurden die folgenden Elektrotauchlackierbäder eingesetzt:

| A: | 200 g | Epoxidharz (R)Resydrol 16989 der Firma Hoechst AG (60 % in Ethylglykol) |
|---|---|---|
| | 2,75 g | Ameisensäure |
| | 797 ml | Wasser |
| B: | wie A, aber mit zusätzlich 33 g Härter SWX 596 | |
| C: | 200 g | Epoxidharz (R)Resydrol SWE 5186 |
| | 2,75 g | Ameisensäure |
| | 797 ml | Wasser |
| D: | 174 g | Epoxidharz (R)Resydrol SVK 5140 (69 %) |
| | 2,8 g | Ameisensäure |
| | 823 ml | Wasser |
| E: | 182 g | Epoxidharz (R)Resydrol SVK 5145 (66 %) |
| | 2,75 g | Ameisensäure |
| | 816 ml | Wasser |

Anodisch abscheidbare Harzlösungen

| F: | 133 g | Acrylatharz (R)Resydrol WY 323 (75 %) |
|---|---|---|
| | 26 g | Melaminharz (R)Maprenal MF 910 (90 %) |
| | 12 g | Diethanolamin |
| | 1250 ml | Wasser |
| G: | 133 g | Melaminharz (R)Resydrol WM 461 E |
| | 12 g | Diisopropanolamin |
| | 1000 ml | Wasser |
| H: | 171 g | Polybutadienharz (R)Resydrol SWP 195 E |
| | 17 g | 10%ige $NH_3$-Lösung |
| | 1000 ml | Wasser |
| I: | 200 g | Maleinsäureaddukt (R)Resydrol SWX 213 E |
| | 20 g | 10%ige $NH_3$-Lösung |
| | 1000 ml | Wasser |

Zur besseren Verankerung können die bildmäßigen Abscheidungen noch thermisch (5 min, 100 °C) nachgehärtet werden.

Die Beispiele 1 bis 37 wurden als kataphoretische Lacke abgeschieden, die Beispiele 38 bis 51 anaphoretisch (Substrat als Anode).

Tabelle 1

| Bei-spiel Nr. | Art des Elektro-lyten | Spannung V | Zeit sec | Nachhär-tung | Qualität der Ab-scheidungs- und Farb-annahme |
|---|---|---|---|---|---|
| 1 | A | 10 | 1 | - | gut |
| 2 | A | 20 | 1 | - | sehr gut |
| 3 | A | 20 | 2,5 | - | sehr gut |
| 4 | A | 20 | 5 | - | sehr gut |
| 5 | A | 40 | 2,5 | - | sehr gut |
| 6 | A | 40 | 5 | - | sehr gut |
| 7 | A | 60 | 1 | - | sehr gut |
| 8 | A | 60 | 3 | - | sehr gut |
| 9 | A | 60 | 5 | - | sehr gut |
| 10 | A | 80 | 0,1 | - | sehr gut |
| 11 | A | 80 | 1 | - | sehr gut |
| 12 | A | 100 | 0,01 | - | sehr gut |
| 13 | A | 100 | 0,1 | - | sehr gut |
| 14 | A | 100 | 1 | - | sehr gut |

Tabelle 1 (Fortsetzung I)

| Bei-spiel Nr. | Art des Elektro-lyten | Spannung V | Zeit sec | Nachhär-tung | Qualität der Ab-scheidungs- und Farb-annahme |
|---|---|---|---|---|---|
| 15 | A | 200 | 0,001 | – | sehr gut |
| 16 | A | 200 | 0,01 | – | sehr gut |
| 17 | A | 200 | 0,1 | – | sehr gut |
| 18 | A | 200 | 1 | – | sehr gut |
| 19 | B | 10 | 5 | – | sehr gut |
| 20 | B | 20 | 1 | – | sehr gut |
| 21 | B | 20 | 2,5 | – | sehr gut |
| 22 | B | 20 | 5 | – | sehr gut |
| 23 | B | 40 | 2,5 | – | sehr gut |
| 24 | B | 40 | 5 | – | sehr gut |
| 25 | C | 20 | 5 | – | gut |
| 26 | C | 20 | 10 | – | gut |
| 27 | C | 40 | 2,5 | – | gut |
| 28 | C | 40 | 5 | – | gut |
| 29 | D | 10 | 1 | – | sehr gut |
| 30 | D | 10 | 10 | – | sehr gut |
| 31 | D | 20 | 10 | – | sehr gut |
| 32 | D | 40 | 1 | – | sehr gut |
| 33 | E | 10 | 1 | – | sehr gut |
| 34 | E | 20 | 15 | – | sehr gut |
| 35 | E | 30 | 20 | – | sehr gut |
| 36 | E | 40 | 10 | – | sehr gut |
| 37 | E | 40 | 15 | – | sehr gut |

9

Tabelle 1 (Fortsetzung II)

| Bei-<br>spiel<br>Nr. | Art des<br>Elektro-<br>lyten | Spannung<br>V | Zeit<br>sec | Nachhär-<br>tung | Qualität<br>der Ab-<br>scheidungs-<br>und Farb-<br>annahme |
|---|---|---|---|---|---|
| 38 | F | 40 | 30 | ja | sehr gut |
| 39 | G | 40 | 1 | ja | sehr gut |
| 40 | G | 40 | 5 | ja | sehr gut |
| 41 | G | 60 | 0,5 | ja | sehr gut |
| 42 | G | 60 | 1 | ja | sehr gut |
| 43 | G | 210 | 0,00 | ja | sehr gut |
| 44 | G | 210 | 0,01 | ja | sehr gut |
| 45 | G | 210 | 0,1 | ja | sehr gut |
| 46 | G | 210 | 1 | ja | sehr gut |
| 47 | H | 200 | 5 | ja | sehr gut |
| 48 | I | 20 | 15 | ja | gut |
| 49 | I | 30 | 15 | ja | sehr gut |
| 50 | I | 40 | 2 | ja | sehr gut |
| 51 | I | 80 | 1 | ja | sehr gut |

In der folgenden Tabelle 2 sind die Druckauflagen einiger der oben angeführten Beispiele angegeben.

Tabelle 2

| Beispiele Nr. | Auflage in Tausend |
|---|---|
| 2 | 80 |
| 29 | 100 |
| 33 | 100 |
| 45 | 150 |
| 47 | 170 |

Beispiel 52

Die Harzlösung F wird mit 20 g eines Polykondensationsproduktes aus 1 mol 3-Methoxy-diphenylamin-4-diazoniumsulfat und 1 mol 4,4'-Bis-methoxymethyl-diphenylether, ausgefällt als Methylsulfonat, dispergiert und als Elektrotauchlack eingesetzt. In der so präparierten Lösung wird eine aufgerauhte und anodisierte Aluminiumplatte für 2 s bei 30 V anodisch geschaltet, und es resultiert eine bildmäßig beschichtete Platte, deren Beschichtung noch lichtempfindlich ist (negativ arbeitend) und einer Zweitstrukturierung durch normale Belichtung mit UV zugänglich ist.

10

Beispiel 53

Die Harzlösung B wird mit 20 g eines Polykondensationsproduktes aus 1 mol 3-Methoxy-diphenylamin-4-diazoniumsulfat und 1 mol 4,4'-Bis-methoxymethyl-diphenylether, ausgefällt als Methylsulfonat, dispergiert und als Elektrotauchlack eingesetzt. In der so präparierten Lösung wird eine aufgerauhte und anodisierte Aluminiumplatte für 5 s bei 10 V kathodisch geschaltet, und es resultiert eine bildmäßig beschichtete Platte, deren Beschichtung noch lichtempfindlich ist (negativ arbeitend) und einer Zweitstrukturierung durch normale Belichtung mit UV zugänglich ist.

**Patentansprüche**

1. Verfahren zur einstufigen Bilderzeugung durch elektrochemische Abscheidung einer polymeren organischen Substanz auf einem leitfähigen Substrat, wobei das Substrat mit einer elektrisch leitfähigen, wäßrigen Lösung der organischen Substanz kontaktiert ist und zwischen dem Substrat und mindestens einer Elektrode eine Gleichspannung anliegt und daß die organische Substanz bei einer Stromdichte von etwa 0,01 bis 100 A/dm$^2$ durch Stromimpulse bildmäßig abgeschieden wird.

2. Verfahren nach Anspruch 1, dadurch gekennzeichnet, daß die organische Substanz ein Polymer ist.

3. Verfahren nach Anspruch 1 oder 2, dadurch gekennzeichnet, daß die Konzentration der organischen Substanz 0,1 Gew.-% bis zur Sättigungsgrenze beträgt.

4. Verfahren nach Anspruch 3, dadurch gekennzeichnet, daß die Konzentration bis zu 20 Gew.-% beträgt.

5. Verfahren nach einem der Ansprüche 1 bis 4, dadurch gekennzeichnet, daß man die Substanz durch eine Maske auf dem Substrat abscheidet.

6. Verfahren nach einem der Ansprüche 1 bis 5, dadurch gekennzeichnet, daß man als Substrat ein Metall einsetzt.

7. Verfahren nach Anspruch 6, dadurch gekennzeichnet, daß das Metall Aluminium ist.

8. Verfahren nach einem der Ansprüche 1 bis 7, dadurch gekennzeichnet, daß man als Substrat ein aufgerauhtes und/oder anodisiertes Metall einsetzt.

9. Verfahren nach einem der Ansprüche 1 bis 8, dadurch gekennzeichnet, daß man ein bebildertes und entwickeltes Substrat einsetzt, wobei sich die abzuscheidende Substanz in den Nichtbildstellen niederschlägt und nach dem Entfernen der ursprünglichen Bildstellen aus einer Positivform eine Negativform - oder umgekehrt - entsteht.

10. Verfahren nach einem der Ansprüche 1 bis 9, dadurch gekennzeichnet, daß die organische Substanz zusätzlich strahlungsempfindliche Bestandteile enthält oder diese vor der Abscheidung zugemischt werden.

11. Verfahren nach einem der Ansprüche 1 bis 10, dadurch gekennzeichnet, daß der pH-Wert der elektrisch leitfähigen Lösung im Bereich von 2 bis 10 liegt.

12. Verfahren nach einem der Ansprüche 1 bis 11, dadurch gekennzeichnet, daß man die elektrisch leitfähige Lösung beim Arbeiten ohne Eintauchen in Gelform einsetzt.

13. Verfahren nach einem der Ansprüche 1 bis 12, dadurch gekennzeichnet, daß man die organische Substanz mittels wenigstens einer Nadelelektrode abscheidet.

**Claims**

1. Process for the single-stage image formation by electrochemical deposition of a polymeric organic substance on a conductive substrate being in contact with an electrically conductive aqueous solution of an organic substance and a direct voltage being applied between the substrate and at least one electrode, and the organic substance being deposited in image configuration by current impulses, at a current density from about 0.01 to 100 A/dm$^2$.

2. A process as claimed in claim 1, wherein the organic substance is a polymer.

3. A process as claimed in claim 1 or 2, wherein the concentration of the organic substance is from 0.1 % by weight up to the saturation limit.

4. A process as claimed in claim 3, wherein the concentration is up to 20 % by weight.

5. A process as claimed in any of claims 1 to 4, wherein the substance is deposited through a mask onto the substrate.

6. A process as claimed in any of claims 1 to 5, wherein a metal is used as the substrate.

7. A process as claimed in claim 6, wherein the metal is aluminum.

8. A process as claimed in any of claims 1 to 7, wherein a grained and/or anodized metal is used as the substrate.

9. A process as claimed in any of claims 1 to 8, wherein an imaged and developed substrate is used, the substance to be deposited precipitating in the non-image areas and a negative form being produced from a positive form - or vice versa - after removal of the original image areas.

10. A process as claimed in any of claims 1 to 9, wherein the organic substance additionally contains radiation-sensitive constituents or the latter are admixed prior to deposition.

11. A process as claimed in any of claims 1 to 10, wherein the pH of the electrically conductive solution is in the range from 2 to 10.

12. A process as claimed in any of claims 1 to 11, wherein the electrically conductive solution is used in the form of a gel when operating without dipping.

13. A process as claimed in any of claims 1 to 12, wherein the organic substance is deposited by means of at least one stylus electrode.

**Revendications**

1. Procédé de production d'image en une étape par dépôt électrochimique d'une substance organique polymère sur un substrat conducteur, dans lequel ledit substrat est mis en contact avec une solution aqueuse électroconductrice de la substance organique et une tension continue est appliquée entre le substrat et au moins une électrode, et la substance organique est déposée, selon une image, par impulsions de courant, avec une densité de courant de l'ordre de 0,01 à 100 A/dm$^2$.

2. Procédé selon la revendication 1, caractérisé en ce que la substance organique est un polymère.

3. Procédé selon la revendication 1 ou 2, caractérisé en ce que la concentration de la substance organique est comprise entre 0,1 % en poids et la limite de saturation.

4. Procédé selon la revendication 3, caractérisé en ce que la concentration peut atteindre 20 % en poids.

5. Procédé selon une des revendications 1 à 4, caractérisé en ce que la substance se dépose sur le substrat à travers un masque.

6. Procédé selon une des revendications 1 à 5, caractérisé en ce que le substrat est constitué d'un métal.

7. Procédé selon la revendication 6, caractérisé en ce que le métal est l'aluminium.

**8.** Procédé selon une des revendications 1 à 7, caractérisé en ce que le substrat est un métal grainé et/ou anodisé.

**9.** Procédé selon une des revendications 1 à 8, caractérisé en ce qu'on utilise un substrat recouvert d'image et développé, la substance à déposer précipitant dans les zones de non-image et une forme négative se formant à partir d'une forme positive, ou vice versa, après élimination des zones d'image originelles.

**10.** Procédé selon une des revendications 1 à 9, caractérisé en ce que la substance organique contient en outre des constituants sensibles aux radiations, ou bien que ces derniers sont ajoutés au mélange avant le dépôt.

**11.** Procédé selon une des revendications 1 à 10, caractérisé en ce que le pH de la solution conductrice de l'électricité est de 2 à 10.

**12.** Procédé selon une des revendications 1 à 11, caractérisé en ce que la solution conductrice de l'électricité est utilisée sous forme de gel lorsqu'on opère sans immersion.

**13.** Procédé selon une des revendications 1 à 12, caractérisé en ce que la substance organique est déposée à l'aide d'au moins une électrode en forme d'aiguille.

Fig. 1

Fig. 2